Europäisches Patentamt

European Patent Office

Office européen des brevets

(11) Veröffentlichungsnummer: **0 007 549**

**A1**

## (12) EUROPÄISCHE PATENTANMELDUNG

(21) Anmeldenummer: 79102475.5

(22) Anmeldetag: 16.07.79

(51) Int. Cl.³: **G 01 R 11/20**

(30) Priorität: 24.07.78 DE 2832421

(43) Veröffentlichungstag der Anmeldung:
06.02.80 Patentblatt 80/3

(84) Benannte Vertragsstaaten:
AT CH GB IT

(71) Anmelder: SIEMENS AKTIENGESELLSCHAFT Berlin
und München
Postfach 261
D-8000 München 22(DE)

(72) Erfinder: Schreiner, Heinz
Pirolweg 13
D-8500 Nürnberg(DE)

(72) Erfinder: Weinicke, Martin
Bibertstrasse 50
D-8500 Nürnberg-Gebersdorf(DE)

(72) Erfinder: Wodschadlo, Kurt
Mindelhelmer Strasse 71
D-8500 Nürnberg-Gaulnhofen(DE)

(72) Erfinder: Schmidt, Manfred
Gutzberger Strasse 36
D-8504 Stein(DE)

(54) Phasenabgleichsvorrichtung für Elektrizitätszähler.

(57) Eine Phasenabgleichsvorrichtung für Elektrizitätszähler mit einer beide Schenkel des Stromeisens (1) umgebenden Kurzschlußwindung (3) ist so ausgebildet, daß die die beiden Schenkel umgebende Kurzschlußwindung (3) und die in Reihe mit dieser liegende Abgleichsschleife (6) aus einem einteiligen Blech mit positivem Temperaturkoeffizienten gestanzt und derart geformt ist, daß die Flüsse in beiden Schenkeln des Stromeisens (1) gleichmäßig belastet sind, wenn der Widerstand der Abgleichsschleife (6) mittels einer verschiebbaren Kontaktbrücke (9) verändert wird. Durch die symmetrische Belastung der Flüsse in den beiden Schenkeln des Stromeisens (1) werden die temperaturabhängigen Spannungs- und Stromleertriebe verhindert. Deshalb kann auch als Material Kupfer verwendet werden, dessen positiver Temperaturkoeffizient mit steigender bzw. fallender Temperatur den Widerstandswert der Abgleichsvorrichtung erhöht bzw. verringert. Damit wird eine temperaturabhängige Änderung des Abgleichswinkels erreicht, so daß der temperaturabhängige Winkelfehler des Zählers verringert wird.

EP 0 007 549 A1

./...

FIG 1

FIG 2

SIEMENS AKTIENGESELLSCHAFT                    Unser Zeichen
Berlin und München                            VPA 78 P 3 1 2 5 EUR

Phasenabgleichsvorrichtung für Elektrizitätszähler

Die Erfindung bezieht sich auf eine Phasenabgleichsvorrichtung für Elektrizitätszähler der im Oberbegriff des
Anspruches 1 genannten Art.

Eine Phasenabgleichsvorrichtung dieser Art ist durch die
DE-AS 10 13 006 bekannt geworden. Bei dieser bekannten
Phasenabgleichsvorrichtung werden die beiden nebeneinander liegenden Kurzschlußwindungen auf die beiden Schenkel
des Stromeisens geschoben. Während die eine Windung mit
der Widerstandsschleife verbunden ist, auf der die Kontaktbrücke verschiebbar befestigt ist, läuft die andere Windung
in einer Schiene aus, die über Stege mit der Widerstandsschleife in Verbindung steht. Zum Grobausgleich werden
dabei so viele Stege unterbrochen, bis man den verbleibenden erforderlichen Abgleich durch Verschieben der
Kontaktbrücke erreichen kann. Durch den Grob- und Feinabgleich werden die Flüsse in den beiden Schenkeln des
Stromeisens ungleichmäßig belastet, so daß Spannungs-

12.7.1978 / Hs 2 Mit

und Stromleertriebe zu erwarten sind, die ein Nachstellen des Zählers erforderlich machen und damit den Justieraufwand erhöhen. Diese Leertriebe verursachen außerdem temperaturabhängige Zusatzfehler.

Außerdem ist sie aus zwei aneinanderstoßenden und leitend verbundenen Blechen gestanzt, von denen das eine eine große und das andere eine diesem gegenüber kleine elektrische Leitfähigkeit besitzt. Zur Erzielung einer gewünschten Temperaturcharakteristik muß sie aus Blechen mit einem entsprechenden Temperaturkoeffizienten bestehen. Auch die Herstellung einer solchen Abgleichsvorrichtung ist sehr aufwendig.

Durch das DE-GM 77 17 384 ist eine einfache Phasenabgleichsvorrichtung bekannt geworden, bei der aber nur ein Schenkel des Stromeisens mit einer Kurzschlußwindung versehen ist, die in eine einseitig angeformte, mit einer verstellbaren Kurzschlußbrücke versehene Widerstandsschleife ausläuft. Durch den unsymmetrischen Aufbau werden auch hier die Flüsse in den beiden Schenkeln unsymmetrisch belastet, so daß man zur Vermeidung von Spannungs- und Stromleertrieben und deren Temperaturabhängigkeit auch hier gezwungen ist, ein Material mit geringem Temperaturkoeffizienten, wie Messing zu verwenden. Bei gleichem Widerstand ist jedoch Messing teurer als Kupfer. Dazu kommt der erhöhte Justieraufwand durch das Nachstellen des Zählers.

Der Erfindung liegt die Aufgabe zugrunde, eine Phasenabgleichvorrichtung der eingangs beschriebenen Art derart auszubilden, daß nicht nur die Herstellung, Montage und Justierung einfacher ist, sondern auch ein billigeres Material für die Abgleichbrille verwendet werden kann.

Die Phasenabgleichvorrichtung gemäß der Erfindung ist durch die im kennzeichnenden Teil des Anspruches 1 angegebenen Merkmale gekennzeichnet. Durch die symmetrische Belastung der Flüsse in den beiden Schenkeln des Stromeisens werden die temperaturabhängigen Spannungs- und Stromleertriebe verhindert. Deshalb kann auch als Material Kupfer verwendet werden, dessen positiver Temperatur-Koeffizient mit steigender bzw. fallender Temperatur den Widerstandswert der Abgleichsvorrichtung erhöht bzw. verringert. Damit wird eine temperaturabhängige Änderung des Abgleichwinkels erreicht, so daß der temperaturabhängige Winkelfehler des Zählers verringert wird. Durch den symmetrischen Aufbau kann auch der Justieraufwand erheblich herabgesetzt werden, weil keine Rückwirkung auf den Kleinlastwert auftritt und die sonst erforderliche Nachstellung entfällt.

Anhand der Zeichnung, in der ein Ausführungsbeispiel dargestellt ist, wird die Erfindung näher erläutert. Es zeigen

Figur 1 eine schaubildliche Darstellung des mit einer Abgleichs-Vorrichtung versehenen Stromeisens eines Elektrizitätszählers,

Figur 2 eine Abgleichbrille gemäß der Erfindung.

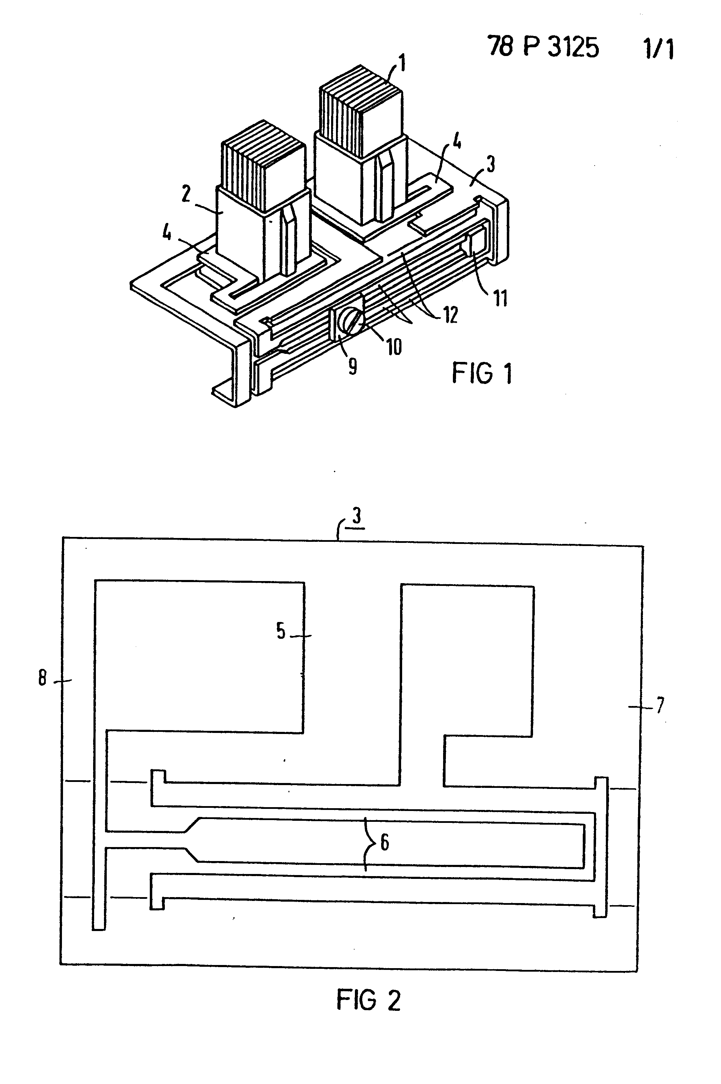

In Figur 1 ist mit 1 ein U-förmiges Stromeisen bezeichnet, das mit einem Spulenkörper 2 für die nicht dargestellte Stromspule zeigt. Auf den beiden Schenkeln sind die erfindungsgemäße Abgleichsbrille 3 und weiter in sich geschlossene Abgleichbleche 4 aufgelegt. Die Abgleichbleche 4 dienen in an sich bekannter Weise zum Grobabgleich. In Figur 1 ist jeder Schenkel des Stromeisens 1 nur mit einem solchen Abgleichblech 4 versehen.

In Figur 2 ist die als Stanzteil ausgebildete Abgleichbrille nach dem Stanzvorgang dargestellt. Wie daraus zu
ersehen ist, ist in Reihe mit dem zwischen den beiden
Schenkeln des Stromeisens 1 verlaufenden Teil 5 die Abgleichschleife 6 angeordnet. Die beiden außen um die
Stromeisenschenkel herumführenden Teile 7 und 8 der Kurzschlußwindung 3 sind so bemessen, daß sie den gleichen
ohmschen Widerstand aufweisen. Wie Figur 1 zeigt, ist
auf den beiden Teilen der Widerstandsschleife 6 eine
Kontaktbrücke 9 verschiebbar angeordnet; sie kann nach
dem Abgleich mit einer Schraube 10 festgeklemmt werden.
Durch eine am Spulenkörper 2 angeformte Nase 11 und Stege
12 ist die Widerstandsschleife 6 formschlüssig festgelegt.

Für die Montage auf den Stromeisen wird die gestanzte
Abgleichbrille 3 U-förmig, vorzugsweise automatisch, gebogen.

Das verwendete Material für die Abgleichbrille hat vorzugsweise einen positiven Temperaturkoeffizienten, so
daß nur kleine Temperaturwinkelfehler im Zähler auftreten.

<u>Patentansprüche</u>

1. Phasenabgleichsvorrichtung für Elektrizitätszähler,
mit einer beide Schenkel des Stromeisens umgebenden Kurzschlußwindung, die zusammenhängend mit einer sie belastenden Abgleichsschleife gestanzt ist, in deren ausgestanzter
Innenfläche zur Einstellung ihres Widerstandes eine verschiebbare Kontaktbrücke angeordnet ist, d a d u r c h
g e k e n n z e i c h n e t , daß die die beiden Schenkel
umgebende Kurzschlußwindung (3) und die in Reihe mit
dieser liegende Abgleichsschleife (6) aus einem einteiligen Blech mit positivem Temperaturkoeffizienten gestanzt
und derart geformt sind, daß die Flüsse in beiden Schenkeln
des Stromeisens (1) gleichmäßig belastet sind, wenn der
Widerstand der Abgleichschleife verändert wird.

2. Phasenabgleichsvorrichtung nach Anspruch 1, d a d u r c h
g e k e n n z e i c h n e t , daß die Abgleichschleife
(6) in Reihe mit dem zwischen den beiden Schenkeln des
Stromeisens (1) verlaufenden Teil (5) der Kurzschlußwindung (3) angeordnet ist, und daß die beiden außen um
die Stromeisenschenkel herumführenden Teile (7,8) der
Kurzschlußwindung (3) so dimensioniert sind, daß sie den
gleichen ohmschen Widerstand aufweisen.

3. Phasenabgleichsvorrichtung nach Anspruch 1 oder 2,
d a d u r c h   g e k e n n z e i c h n e t , daß die
Kurzschlußwindung (3) mit Abgleichschleife (6) an einem
die Stromspule des Zählers aufnehmenden  Isolierkörper
(2) formschlüssig befestigt ist.

FIG 1

FIG 2

0007549

| | | | Nummer der Anmeldung |
|---|---|---|---|
| Europäisches Patentamt | | **EUROPÄISCHER RECHERCHENBERICHT** | EP 79 102 475.5 |

| | EINSCHLÄGIGE DOKUMENTE | | KLASSIFIKATION DER ANMELDUNG (Int Cl.3) |
|---|---|---|---|
| Kategorie | Kennzeichnung des Dokuments mit Angabe, soweit erforderlich, der maßgeblichen Teile | betrifft Anspruch | |
| A | <u>US - A - 2 336 834</u> (H.A. BAKKE)<br>* Seite 2, linke Spalte, Zeile 32 bis rechte Spalte, Zeile 69; Fig. 1, 2, 3 *<br>-- | 1,2 | G 01 R  11/20 |
| | <u>DE - A1 - 2 347 249</u> (SIEMENS)<br>* Ansprüche 1,2, 3; Seite 2, Absatz 2, 3; Fig. 1b, 1c *<br>-- | 1,2,3 | |
| | <u>DE - B - 1 015 006</u> (LICENTIA)<br>* ganzes Dokument *<br>----- | | RECHERCHIERTE SACHGEBIETE (Int Cl.)<br><br>G 01 R  11/20 |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Berlin | 24-10-1979 | LIMBERLER |